# EUROPEAN PATENT APPLICATION

(11) **EP 2 213 761 A1**
(43) Date of publication of application: **04.08.2010**
(21) Application number: 08853802.0
(22) Date of filing: 28.11.2008
(51) Int. Cl.: C23C 14/04

(54) **SUBSTRATE PROCESSING APPARATUS AND SUBSTRATE PROCESSING METHOD**

(30) Priority: 30.11.2007 JP 2007310894
(71) Applicant: Canon Anelva Corporation, Asao-ku Kawasaki-shi Kanagawa 215-8550 (JP)
(72) Inventor: SASAKI, Masao, Kawasaki-shi Kanagawa 215-8550 (JP)
(74) Representative: Musker, David Charles
(86) International application number: PCT/JP2008/071639
(87) International publication number: WO 2009/069743

(57) **Abstract**

This invention provides a substrate processing apparatus and a substrate processing method for improving the adhesion of a patterned region which is a relatively thin region of a metal mask to a substrate. According to one embodiment of this invention, in a method for fixing a metal mask (006) to be in intimate contact with a surface to be processed of a substrate (005) using a magnet (007), the metal mask (006) has a thick region and a thin region. The magnet (007) has at least one border between N and S poles on a side facing the substrate (005) and is formed such that the border faces only a thick region of the metal mask (006).

## Description

### TECHNICAL FIELD

The present invention relates to a substrate processing apparatus and a substrate processing method for arranging a mask on a substrate and performing predetermined pattern processing on the substrate and particularly to a substrate processing apparatus and a substrate processing method used to arrange a metal mask on a surface of a substrate to form a thin-film pattern.

### BACKGROUND ART

Along with recent miniaturization of a pattern formed on a substrate, the need for improvement in the accuracy of pattern processing (in particular, improvement in the position accuracy of pattern in film formation processing that is one of types of the processing) has arisen, and the thickness of a metal mask has become smaller. This is because if a metal mask is thick, a fine opening falls under the shadow of the metal mask, and a deposition particle which enters the fine opening in the metal mask obliquely with respect to a substrate does not reach the substrate. This raises the need to form a metal mask as thin as possible.

In an actual metal mask, only a patterned region with fine openings is formed to be thin, and a non-deposition (non-film-forming) region without openings is formed to be thick, in consideration of maintainability.

If there is a space between a metal mask and a substrate, a patterned deposition position on the substrate may be shifted or a pattern may be blurred. It is important for prevention of these problems to form the metal mask in intimate contact with the substrate so as not to leave a space therebetween. At this time, all of patterned regions of the metal mask need to be in intimate contact with the substrate.

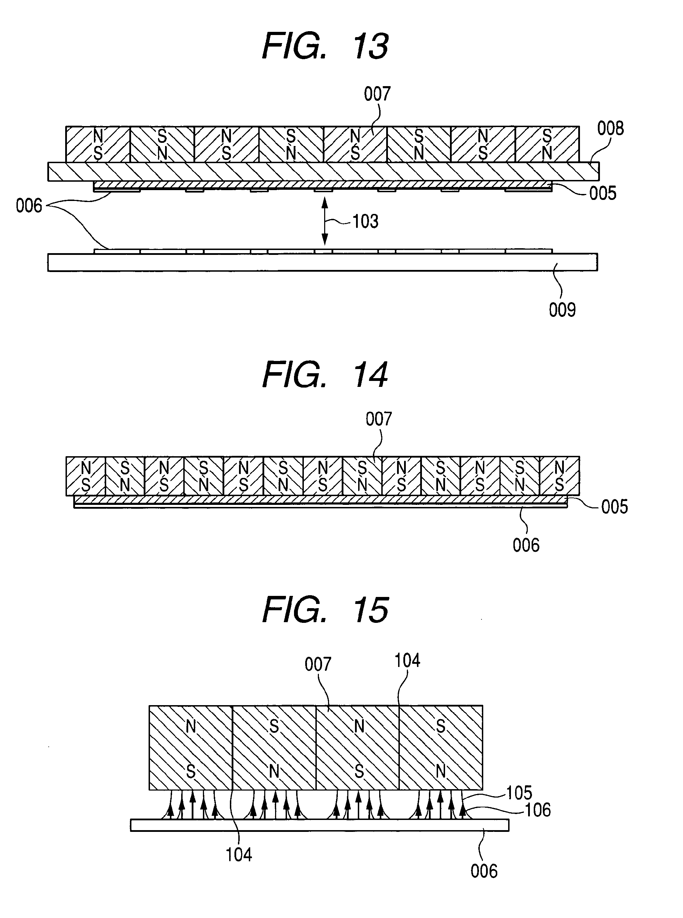

To cope with this, a configuration in which a magnet 007 is placed on the opposite side of a surface of a substrate 005 where a metal mask 006 is to be placed, and the metal mask 006 made of a magnetic substance is brought into intimate contact with the substrate 005 by magnetic force of the magnet 007, as shown in FIG. 14, has been proposed (see Patent Documents 1 and 2).
Patent Document 1: Japanese Patent Publication No. H6-51905
Patent Document 2: Japanese Patent Application Laid-Open No. 2002-75639

### DISCLOSURE OF THE INVENTION

Patent Documents 1 and 2 each disclose a magnet structure in which directions of magnetization alternate, as shown in FIG. 14. Use of such a magnet increases the magnitude of magnetic force which acts on a metal mask and improves the adhesion of the metal mask to a substrate.

However, as shown in FIG. 15, lines 105 of magnetic force center around the center of a magnetic pole such as an N pole or an S pole in this configuration. The adhesive force of the metal mask 006 increases at a portion around the center of each pole while the adhesive force of the metal mask 006 hardly acts at a portion facing (corresponding to) a border portion 104 between N and S poles.

If a metal mask is thick, since the metal mask has sufficient rigidity, a reduction in local adhesive force is not a serious problem. The thinner a metal mask, the more likely a space is to be formed between a substrate and the metal mask at a portion of thin metal mask due to a reduction in local adhesive force.

Under the circumstances, the present invention has as its object to improve the adhesion of a patterned region which is a relatively thin region of a metal mask to a substrate in consideration of the above-described problem with the background art.
A first aspect of the present invention is a substrate processing apparatus comprising a magnet which is arranged on a side opposite to a surface to be processed of a substrate at the time of processing the substrate and has a border portion between N and S poles and a magnetic mask which is arranged to face the surface to be processed of the substrate at the time of processing the substrate and has a patterned region and a frame region, the frame region having a thickness larger than a thickness of the patterned region, wherein the frame region is made to face the border portion.
A second aspect of the present invention is a method of arranging a magnetic mask which has a patterned region and a frame region, the frame region having a thickness larger than a thickness of the patterned region, on one surface of a substrate, arranging a magnet which has a border portion between N and S poles on a side opposite to the one surface to bring the magnetic mask into contact with the substrate by magnetic force of the magnet, and processing the surface of the substrate through the magnetic mask, comprising: a step of arranging the magnet and the magnetic mask such that the frame region faces the border portion between N and S poles at the time of the above-described contact.

According to the present invention, it is possible to, in a method for bringing a metal mask made of a magnetic substance into intimate contact with a surface to be processed of a substrate using a magnet, improve the adhesion of a patterned region which is a relatively thin region of the metal mask to the substrate.

### BRIEF DESCRIPTION OF THE DRAWINGS

FIG. 1 is an overall configuration view showing an example of a substrate processing apparatus for performing a substrate processing method according to the present invention;
FIG. 2 is a cross-sectional view showing how a metal mask is set on a substrate to be processed in the present invention and is a view of a metal mask holding mechanism;
FIG. 3 is a plan view showing an example of a metal mask used in the present invention;
FIG. 4 is a perspective view showing an example of a magnet used in the present invention;
FIG. 5 is a cross-sectional view showing an example of the positional relationship between the magnet and the metal mask used in the present invention;
FIG. 6 is a cross-sectional view showing another example of the configuration of the magnet used in the present invention;
FIG. 7 is a cross-sectional view showing still another example of the configuration of the magnet used in the present invention;
FIG. 8 is a cross-sectional view showing force of the magnet according to the present invention which acts on the metal mask;
FIG. 9A is a view showing an analytical model when the amount of deformation of the mask due to its self weight is structurally analyzed;
FIG. 9B is a chart showing the result of calculating the analytical model shown in FIG. 9A;
FIG. 9C is a graph of the calculation result in FIG. 9B;
FIG. 10 is a cross-sectional view showing an example of a configuration when a metal mask is set on a substrate to be processed in the present invention;
FIG. 11 is a cross-sectional view showing another example of the configuration when the metal mask is set on the substrate to be processed in the present invention;
FIG. 12 is a cross-sectional view showing still another example of the configuration when the metal mask is set on the substrate to be processed in the present invention;
FIG. 13 is a cross-sectional view for explaining a method for setting the metal mask on the substrate to be processed in the present invention;
FIG. 14 is a cross-sectional view showing an example of a conventional configuration in which a metal mask is brought into intimate contact with a substrate using a magnet;
FIG. 15 is a cross-sectional view for explaining an example of the configuration of a conventional method using a magnet;
FIG. 16 is a perspective view of an electron-emissive element display produced by a substrate processing apparatus according to an embodiment of the present invention;
FIG. 17A is a schematic view of an organic fluorescent display produced by a substrate processing apparatus according to an embodiment of the present invention; and
FIGS. 17B are views showing a method for producing the organic fluorescent display shown in FIG. 17A.

### BEST MODE FOR CARRYING OUT THE INVENTION

Embodiments of the present invention will be described below with reference to the drawings.

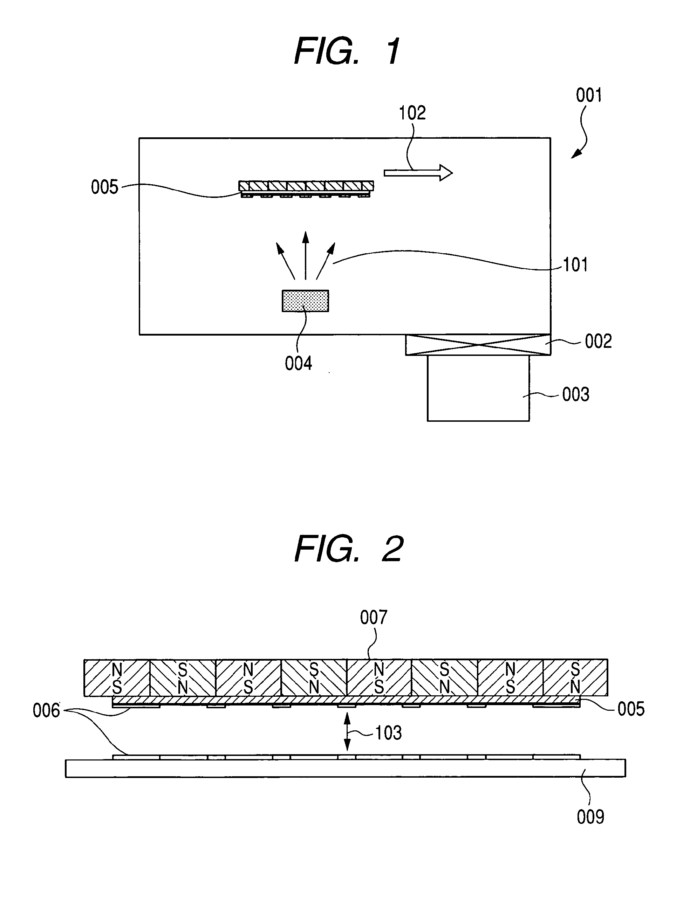

FIG. 1 is an overall configuration view showing an example of a substrate processing apparatus for performing a substrate processing method according to the present invention.

An apparatus shown in FIG. 1 includes a vacuum chamber 001 for processing a substrate in a vacuum. For this reason, a vacuum pump 003 is connected to the vacuum chamber 001 through a gate valve 002. The vacuum chamber 001 is evacuated by the vacuum pump 003 at the time of substrate processing and is kept in a vacuum. The substrate processing apparatus in this example is a film forming apparatus. An evaporation source 004 is placed in the vacuum chamber 001, and a deposition material evaporates in an upward direction 101 from the evaporation source 004. A substrate 005 is conveyed above the evaporation source 004. After that, a metal mask is set, and a film of the deposition material is formed on the substrate 005.

The view at the upper portion of FIG. 2 is a cross-sectional view showing how a metal mask 006 is set on the substrate 005 to be processed, at the time of processing the substrate. Before being brought into intimate contact with the substrate 005, the metal mask 006 is held by a metal mask holding mechanism 009. A magnet 007 is placed on the opposite side of a surface to be processed of the substrate 005. When the metal mask holding mechanism 009 is moved in a direction 103, the metal mask 006 is brought into intimate contact with the surface to be processed of the substrate 005 by magnetic force of the magnet 007.

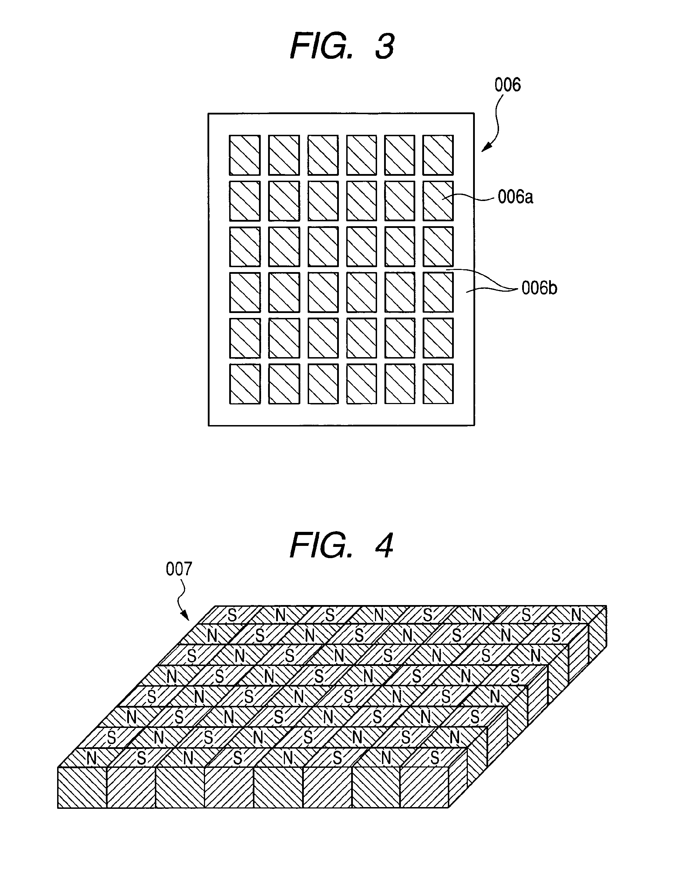

FIG. 3 is a plan view of the metal mask 006.

The metal mask 006 has patterned regions 006a with fine openings for forming a deposition pattern on the surface to be processed of the substrate 005 and frame regions 006b forming the other region. The metal mask 006 is made of a magnetic substance which has the property of being attracted by magnetic force of the magnet 007. For example, an iron-nickel alloy such as invar, nickel, or the like can be used as the magnetic substance. Invar has a low coefficient of thermal expansion and is suitable as the material for the mask. Note that the metal mask 006 may be made of two or more magnetic substances. Examples of this case include one in which the patterned regions 006a are made of Ni, and the frame regions 006b are made of invar. Note that in this embodiment, the material is not limited to the metal, and a magnetic substance such as an inorganic compound may be used. As described above, any material (e.g., a metal mask) may be used as a member for masking a substrate in this embodiment as long as the material functions as a magnetic mask.

Each patterned region 006a is formed to have a thickness smaller than that of each frame region 006b in order to curb the problem that if the patterned region 006a is thick, a fine opening falls under the shadow of the patterned region 006a, and the film thickness of a peripheral portion in the opening becomes small. The thickness of each patterned region 006a is, e.g., about 0.01 mm. The small thickness allows even a film-forming particle which enters a fine opening obliquely to reach the substrate.

On the other hand, each frame region 006b is formed to have a thickness larger than that of each patterned region 006a in consideration of the maintainability and rigidity of the mask. The thickness of each frame region 006b is, e.g., about 1 mm. The frame regions 006b are present between the patterned regions 006a and on the outer periphery of the entire metal mask.

As described above, regions with a small mask thickness and regions with a large mask thickness are mixed in the metal mask 006. The typical width of each frame region which is a portion where the metal mask has a large thickness is about 10 mm, and the typical pattern size of each patterned region is several tens of µm.

An example of the magnet 007 for attracting the metal mask 006 made of a magnetic substance and bringing the metal mask 006 into intimate contact with the surface to be processed is shown in FIG. 4. The size of the entire magnet 007 is equal to or larger than that of the metal mask 006. The magnet 007 is magnetized in its thickness direction (i.e., a direction away from a principal surface of the substrate 005 in FIG. 2, preferably a direction substantially perpendicular to the principal surface of the substrate 005).

A plurality of N poles and a plurality of S poles are present on the side facing the substrate 005 of the magnet 007. A case where the magnet 007 has alternating N poles and S poles at an end face on the substrate 005 side is shown in FIG. 4. A permanent magnet with a simple structure is used as the magnet 007.

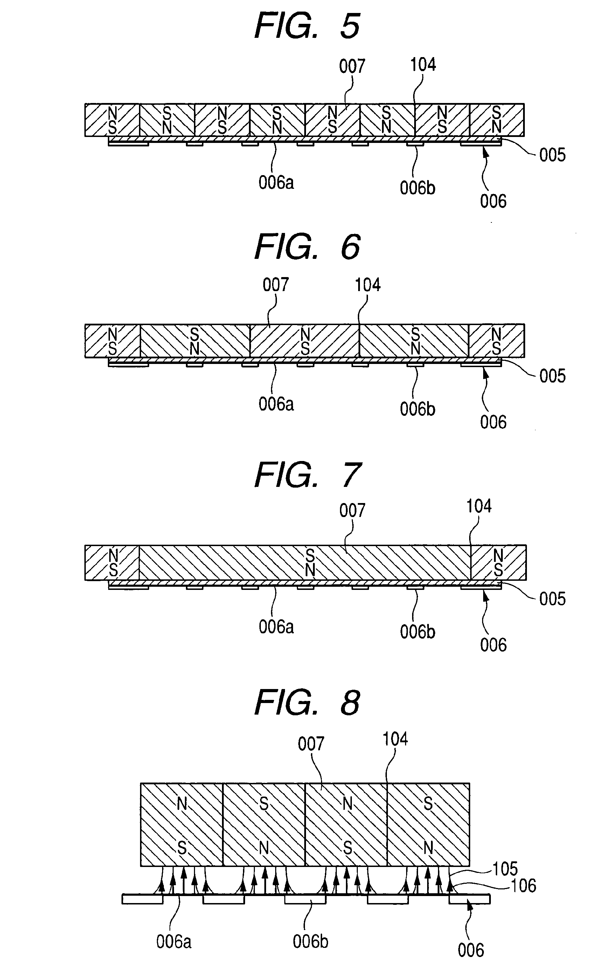

The positional relationship between the magnet 007 and the metal mask 006 according to the present invention will be described in detail with reference to FIGS. 5 to 7.

The magnet 007 is formed such that a border portion 104 between N and S poles faces (corresponds to) the frame region 006b, which is a region with a relatively large mask thickness, as shown in FIG. 5. Accordingly, no border portion 104 between N and S poles of the magnet 007 faces the patterned region 006a, which is a region with a relatively small mask thickness. A single magnetic pole is arranged to face each patterned region 006a.

Another example of the configuration of the magnet 007 relative to the metal mask 006 will be given. As shown in FIG. 6, each border portion 104 between N and S poles in the magnet 007 faces the frame region 006b of the metal mask 006. The magnet 007 may be configured such that the border portions 104 between N and S poles do not faces all of the frame regions 006b. A single magnetic pole faces adjacent ones of the patterned regions 006a, and each border portion 104 between N and S poles faces the frame region 006b around the adjacent patterned regions 006a.

Still another example of the configuration of the magnet 007 relative to the metal mask 006 will be given. As shown in FIG. 7, each border portion 104 between N and S poles in the magnet 007 faces the frame region 006b on the outer periphery of the metal mask 006. The magnet 007 may be configured such that a single magnetic pole faces all the patterned regions 006a.

The action of the magnet 007 with the above-described configuration will be described. FIG. 8 shows in cross section force of the magnet 007 which acts on the metal mask 006. In FIG. 8, a magnetic force which acts on the metal mask is indicated by an arrow 106. As shown in FIG. 8, since there is no line 105 of magnetic force at each border portion 104 between N and S poles in the magnet 007, magnetic force hardly acts on the metal mask 006. In contrast, since there are many lines 105 of magnetic force around the center of each magnetic pole, a strong magnetic force acts on the metal mask 006 at a portion around the center of each pole. For this reason, the patterned region 006a is strongly attracted to the magnet 007 by magnetic force. At this time, since no border portion 104 between N and S poles faces the patterned region 006a, each patterned region 006a has no region on which the magnetic force 106 hardly acts, and each patterned region 006a comes into intimate contact with a substrate (not shown) with no space therebetween.

Each frame region 006b that is a portion faces the border portion 104 between N and S poles locally has a region on which magnetic force does not act. However, magnetic force acts on a portion of each frame region 006b at short distance from the border portion 104 between N and S poles. Since the frame regions 006b are thicker and have higher rigidity than the patterned regions 006a, each frame region 006b comes into intimate contact with the substrate 005 by magnetic force received by the entire frame region 006b, regardless of any change in local magnetic force. Accordingly, even if each frame region 006b is formed to face the border portion 104 between N and S poles, the portion of the frame region 006b comes into intimate contact with the substrate 005 with no space or a reduced space therebetween.

With the above-described action, all surfaces of the metal mask 006 can be brought into intimate contact with the surface to be processed of the substrate 005.

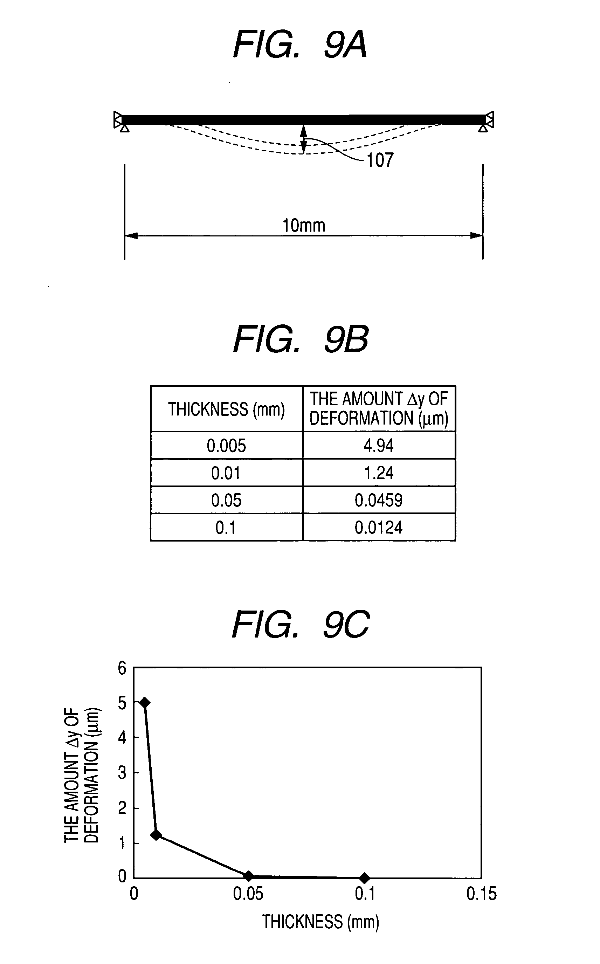

Note that if an evaporation method is used to process the substrate 005, the mask needs to defy gravity in order to deposit, on the substrate, an evaporation material which evaporates upward from the evaporation source. Assume that the present invention is applied to the manufacture of organic EL (which is short for organic electroluminescence display) devices. In this case, since the design rules for organic EL devices are currently several tens of µm, the amount of flotation of a mask due to its self weight needs to be reduced to 1 µm or less in order to suppress nonuniformity of film thickness caused by a space between a mask opening and a substrate. For this reason, an amount 107 of deformation of a mask due to its self weight (i.e., the amount of flotation from a surface of a substrate) when no magnetic force is acting was calculated using structural analysis software ANSYS under the condition that the mask member was made of Ni (Young's modulus: 21.92e10 Pa, Poisson's ratio: 0.306, density: 8850 kg/m³) in the range of 10 mm. The result shows that the amount 107 of deformation was 1.24 µm when the thickness of the mask was 0.01 mm and was 0.0459 µm when the mask thickness was 0.05 mm (see FIGS. 9A to 9C). Accordingly, if the thickness of a mask is 0.05 mm, it is possible to ensure required uniformity of film thickness even if magnetic force does not act sufficiently on some parts.

However, if the thickness of a mask is 0.05 mm or less, the mask itself does not have sufficient rigidity, and the amount of deformation due to self weight is large, as can be seen from the graph in FIGS. 9. Accordingly, it is necessary to fix a mask with such a thickness to a substrate to be in intimate contact with the substrate. Under the circumstances, in the present invention, a metal mask which has the patterned region 006a with a thickness of 0.05 mm or less and is made of a magnetic substance is fixed to be in intimate contact with a surface of a substrate by magnetic force as the metal mask 006 whose suitability as a mask increases with a reduction in thickness. With this configuration, the capability of the present invention is further exerted.

The calculation result shows that the amount of flotation of the mask with the thickness of 0.05 mm was 0.0459 µm. The amount of flotation may be considered to be small enough. However, in consideration of a difference in material, a temperature to be applied to a mask, and a process atmosphere, we have found that it is effective to fix a metal mask having the patterned region 006a with a thickness of 0.05 mm or less to be in intimate contact with a substrate by a magnetic field.

Even in the case of a reduction in local magnetic force, no space or little space is formed between the metal mask 006 and the substrate 005 if the metal mask 006 is thick and has high rigidity. The thickness of the metal mask 6 with sufficient rigidity is 0.1 mm or more. If the thickness of a relatively thick region of the metal mask 006 is 0.1 mm or more, no space or little space is formed between the metal mask 006 and the substrate 005 by a method according to the present invention. This is because, as described above, the amount of flotation due to self weight can be reduced to 0.0124 µm, about 1% or less of an allowable value of 1 µm, as shown in FIG. 9B.
As described above, in this embodiment, each patterned region 006a is preferably formed to be as thin as possible in terms of improvement in film uniformity in the vicinity of an opening formed in the patterned region 006a. The thickness of the patterned regions 006a is preferably 0.05 mm or less. At this time, an amount Δy of deformation due to self weight becomes large, as shown in FIG. 9B, and a space is formed between each patterned region 006a and the substrate 005. To cope with this, in this embodiment, the magnet 007 is arranged such that an N pole or an S pole of the magnet 007 faces each patterned region 006a. Accordingly, even if the film thickness of each patterned region 006a is set to 0.05 mm or less in order to improve the film uniformity in the vicinity of an opening, the adhesion between the patterned regions 006a and the substrate 005 can be improved.
On the other hand, the region of the metal mask 006 except for the patterned regions 006a, i.e., the frame regions 006b are preferably formed to be thick in terms of mechanical strength. If the thickness of each frame region 006b is set to 0.1 mm or more, as shown in FIG. 9B, the amount Δy of deformation can be kept within an allowable range even in the absence of attraction by the magnet at some parts. It is thus preferable to set the thickness of each frame region 006b to 0.1 mm or more.
In this embodiment, when a magnet having at least one border portion between N and S poles is used, a region where only weak magnetic force is produced, i.e., the above-described border portion is designed to face the frame region 006b with sufficient rigidity that does not require attraction by the magnet. Accordingly, even if the thickness of each patterned region 006a is set to a value as small as 0.05 mm or less, it is possible to improve the adhesion between the substrate 005 and the metal mask 006 while improving film uniformity in the vicinity of an opening, by setting the thickness of each frame region 006b to 0.1 mm or more.

From the foregoing, each border portion 104 between N and S poles in the magnet 007 is not made to face the patterned region 006a, which is a region whose mask thickness is relatively small, and is made to face only the frame region 006b, which is a region whose mask thickness is relatively large.

Alignment of a region with a large thickness of a metal mask and a border portion between N and S poles in a magnet relative to each other will be described.
An example of a substrate holding mechanism will be described first. Three or more rod-like L-shaped members (not shown) whose ends are bent at right angles for supporting a substrate are suspended from an upper portion of the chamber. The portions bent at right angles of the three or more rod-like L-shaped members are coplanar with one another. The three or more L-shaped members are arranged outside the magnet 007, and the portions bent at right angles at the ends are configured to be capable of directing at least two positions, a position in an inward direction and a position along the outer periphery of a substrate. The substrate holding mechanism is configured as described above.
A substrate which has been conveyed by a transportation system (not shown) is passed from the transportation system to the lower side of the magnet 007 with a film-forming surface down when the portions bent at right angles of the L-shaped members face inward. Then the metal mask 006 placed on the metal mask holding mechanism 009 is conveyed to below the substrate 005. Note that a portion corresponding to each L-shaped member of each of the metal mask 006 and the metal mask holding mechanism 009 has a notched hole such that the L-shaped member can directly hold the substrate 005.
Alignment of the metal mask 006 and the substrate 005 relative to each other is performed by a method generally used in the field of the art. For example, the alignment of the metal mask and the substrate relative to each other is performed by moving the metal mask holding mechanism 009 under observation with a CCD such that an alignment mark of the metal mask coincides with an alignment mark of the substrate. At this time, alignment of each patterned region 006a of the metal mask relative to the substrate achieves alignment of each frame region 006b, which is a portion with a large mask thickness, relative to the corresponding border portion 104 between N and S poles of the magnet 007. As described above, this is because the width (about 10 mm) of each frame region 006b is larger than the pattern size (several tens of µm) of each patterned region 006a, and alignment of the frame regions 006b is inevitably completed when alignment of the patterned regions 006a is completed.
The alignment method is effective when the substrate 005 is supported by the above-described substrate holding mechanism and deflects slightly for a reason such as a small size of the substrate 005 or a large thickness of the substrate 005.
In order to cause the metal mask 006 to adhere to the substrate 005, after the substrate 005 is brought close to the metal mask, the magnet 007 arranged on the substrate 005 on the opposite side of the metal mask 006 is brought close to the substrate. After that, the metal mask holding mechanism 009 is moved to a position which does not interfere with processing, and processing such as film deposition is performed in this state. Collection of the metal mask 006 can be performed by separating the magnet 007 from the substrate 005 and weakening magnetic force between the metal mask and the magnet and receiving the metal mask 006 by the metal mask holding mechanism 009. Collection of the substrate 005 is performed by moving a substrate receiving portion of the transportation system (not shown) to below the substrate and passing the substrate from the above-described substrate holding mechanism to the substrate receiving portion of the transportation system.

Another embodiment will be described.

As described above, in a configuration in which the magnet 007 is arranged on the substrate 005 on the opposite side of the surface to be processed, the substrate 005 is held at the outer peripheral edge of the substrate 005. However, in the substrate holding configuration, deflection of the substrate 005 increases with an increase in the size of the substrate 005, which may reduce the position accuracy between the substrate 005 and the metal mask 006. When the metal mask 006 is to be attached or detached by moving the magnet 007 close to or away from a surface opposite to the surface to be processed of the substrate 005, a large force may act on the substrate 005 in a direction of the magnet 007 by the metal mask 006 to damage the substrate 005.

For this reason, it is desirable to use an electrostatic chuck as holding means of the substrate 005 and hold the substrate 005 with the entire surface on the opposite side of the surface to be processed of the substrate 005 using the electrostatic chuck. An electrostatic chuck adheres to the entire back surface of a substrate using static electricity and can be used in a vacuum and reduced atmosphere, as in a vacuum chamber.

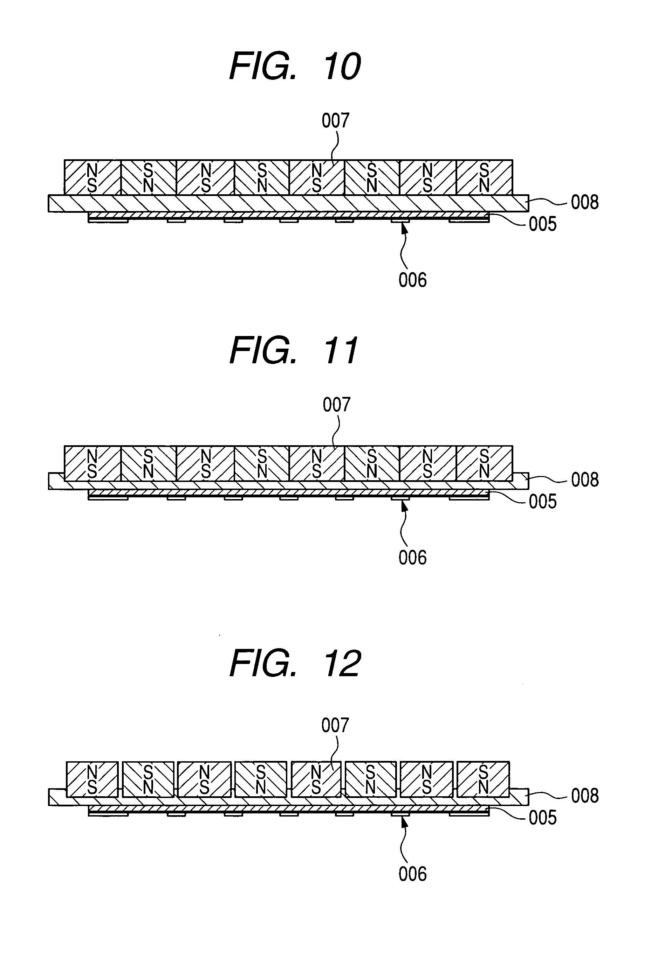

In this embodiment, an electrostatic chuck 008 is inserted between a substrate 005 and a magnet 007, as shown in FIG. 10. A structure in which an electrode is buried in a dielectric layer made of ceramic such as alumina or aluminum nitride can be used as the electrostatic chuck 008. The electrode structure of the electrostatic chuck may be unipolar or bipolar.

Note that the electrostatic chuck 008 inserted between a metal mask 006 and the magnet 007 increases the distance therebetween and weakens magnetic force which acts on the metal mask 006 made of a magnetic substance.

The size of the magnet 007 may be increased or the magnet 007 with strong magnetic force may be used in order to strengthen magnetic force. However, this raises the cost accordingly. If the thickness of a dielectric layer of the electrostatic chuck 008 is reduced, the magnetic force which acts on the metal mask becomes stronger, the strength of the electrostatic chuck 008 itself becomes lower, and the electrostatic chuck 008 becomes likely to be damaged.

For this reason, the portion of the dielectric layer on the magnet 007 side of the electrostatic chuck 008 is thinned except for its outer periphery, as shown in FIG. 11. More specifically, a trench is formed in the dielectric layer except for its outer periphery on the magnet 007 side of the electrostatic chuck 008 to allow the magnet to be placed in the trench. With this configuration, it is possible to reduce the distance between the metal mask 006 and the magnet 007 while maintaining the strength of the electrostatic chuck 008 and strengthen magnetic force which acts on the metal mask 006.

As another aspect, the magnet 007 is divided into small magnets, and a trench corresponding in size to each magnet is formed in the dielectric layer on the magnet 007 side of the electrostatic chuck 008 to allow the magnet to be placed in the trench, as shown in FIG. 12. This aspect also makes it possible to reduce the distance between the metal mask 006 and the magnet 007 while maintaining the strength of the electrostatic chuck 008 and strengthen magnetic force which acts on the metal mask 006.

The configurations shown in FIGS. 11 and 12 eliminate concerns over deflection of the substrate 005 which occurs when the substrate 005 is held and misalignment between the substrate 005 and the metal mask 006. The configurations also eliminate concerns about damage to the substrate 005 caused when the metal mask 006 is attached or detached.

A method for attaching a metal mask to a substrate will be described with reference to FIG. 13.

The substrate 005, which has been conveyed by a transportation system (not shown), is held by the electrostatic chuck 008 with a film-forming surface down. The metal mask 006 is placed on the metal mask holding mechanism 009 with a surface to come into contact with the substrate 005 up and is held below the substrate 005 to be parallel with the substrate 005. The metal mask holding mechanism 009 has a horizontal plate-like portion on which the metal mask 006 is to be placed and a transfer mechanism (not shown).
The metal mask 006 placed on the metal mask holding mechanism 009 moves close to the substrate. Alignment of the metal mask 006 and the substrate 005 relative to each other is performed by a method generally used in the field of the art, such as moving the substrate under observation with a CCD such that an alignment mark of the metal mask 006 coincides with an alignment mark of the substrate 005. After the positions of the substrate 005 and the metal mask 006 are adjusted with an accuracy of several µm in an alignment step, the metal mask 006 is brought into contact with the substrate 005 or is held at an extremely short distance of about several µm from the substrate 005.
The magnet 007 is moved from above the substrate 005 close to the back side of the electrostatic chuck 008, and the metal mask 006 is brought into intimate contact with the substrate 005 by magnetic force. At this time, alignment of each patterned region 006a of the metal mask relative to the substrate achieves alignment of each frame region 006b, which is a portion with a large mask thickness, relative to the corresponding border portion 104 between N and S poles of the magnet. As described above, this is because the width (about 10 mm) of each frame region 006b is larger than the pattern size (several tens of µm) of each patterned region 006a, and alignment of the frame regions 006b is inevitably completed when alignment of the patterned regions 006a is completed.
The mask alignment method using an electrostatic chucking mechanism is effective, e.g., when the size of the substrate 005 is large or the thickness of the substrate 005 is small. This is because the substrate itself is held by the electrostatic chucking mechanism.
After that, processing such as film formation is performed in this state. Collection of the metal mask 006 can be performed by positioning the metal mask holding mechanism 009 immediately below the substrate 005 and then separating the magnet 007 from the substrate 005. Collection of the substrate 005 can be performed by moving a substrate receiving portion of the transportation system (not shown) to below the substrate and weakening chucking force of the electrostatic chuck 008.

The embodiments of the present invention have been described above with reference to the drawings. However, the present invention is not limited to the illustrated structures, and the embodiments may be appropriately modified within the spirit and scope of the present invention.

Note that film formation processing has been described above, the present invention is also applicable to a case where a surface of a substrate is processed through a mask. Substrate processing according to the present invention can be used in the manufacture of a semiconductor integrated circuit element, an organic electroluminescent element, various types of displays such as an electron-emissive element display, and the like.

As examples of an apparatus to be produced by a substrate processing apparatus according to the present invention, an electron-emissive element display (Surface-Conduction Electron-emitter Display; hereinafter also referred to as an SED) and an organic electroluminescence display (hereinafter also referred to as an organic EL display) will be described below.

### (First Embodiment)

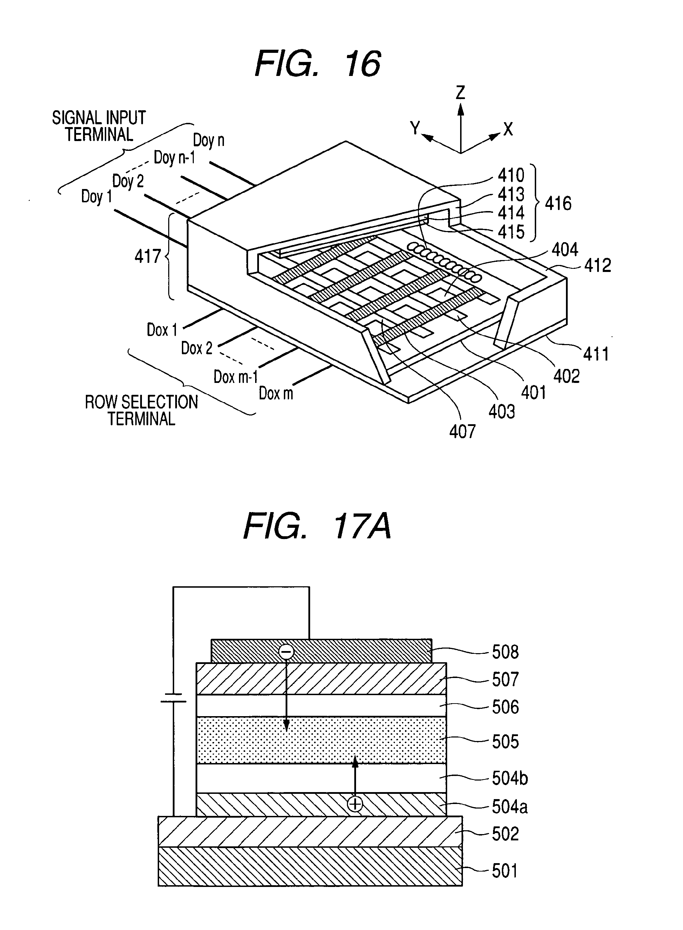

FIG. 16 is a perspective view of an electron-emissive element display which is one of image display apparatuses capable of being produced by applying a substrate processing apparatus according to the present invention. Reference numeral 401 denotes an electron source substrate; 402, a row wire; 403, a column wire; 404, an electron-emissive element; 407, a first getter; 410, a second getter; 411, a reinforcing plate; 412, a frame; 413, a glass substrate; 414, a fluorescent film; and 415, a metal pack. Reference characters Dox 1 to Dox m denote row selection terminals; and Doy 1 to Doy n, column selection terminals. Note that the components 413, 414, and 415 constitute a faceplate 416.
In this display apparatus, each electron-emissive element 404 is arranged at a point where the row wire 402 and the column wire 403 intersect planarly. When a predetermined voltage is applied to the selected row wire 402 and column wire 403, electrons are emitted from the electron-emissive element 404 located at a point where the wires intersect planarly and are accelerated toward the faceplate, to which a high positive voltage is applied. The electrons collide with the metal pack 415 and excite the fluorescent film 414 in contact with the metal pack 415, thereby emitting light.

A space surrounded by the faceplate 416, the frame 412, and the substrate 413 is kept in a vacuum. The getter members are arranged in the space to keep the space in a vacuum over the durable period of the image display apparatus. Getter members include an evaporable getter and a non-evaporable getter, and a choice is appropriately made between these getters. For an evaporable getter, elemental metals such as Ba, Li, Al, Hf, Nb, Ta, Th, Mo, and V and alloys of the metals are known. For a non-evaporable getter, elemental metals such as Zr and Ti and alloys of the metals are known. Each getter is made of a metal and is a conductor.

In the example of FIG. 16, the first getter 407 is formed on the column wire 403. In forming the first getter 407 by the substrate processing apparatus of the present invention, the electron source substrate 401, in which the column wires 403 and components therebelow are formed, is held by an L-shaped member of a substrate holding mechanism as described above. The held electron source substrate 401 is arranged below a magnet 007, and a metal mask 006 which is placed on a metal mask holding mechanism 009 and has the shape of the column wire 403 is conveyed to below the electron source substrate 401. Alignment between the metal mask 006 and the electron source substrate 401 is performed, and the electron source substrate 401 is sandwiched between the magnet 007 and the metal mask 006, thereby forming the first getter 407 by a vacuum deposition method, a sputtering method, chemical vapor deposition, or the like. The thickness of the first getter 407 is about 2 µm.

As for the production of the first getter, since a conductor film which is to finally become the electron-emissive element 404 is already formed, it is important to produce the first getter 407 described above such that the first getter 407 is not electrically continuous with the conductor film. An alignment error allowable at this time is about ±3 µm. If the first getter 407 is produced using a substrate processing apparatus according to the present invention, formation of a space can be suppressed between the electron source substrate 401 and the metal mask 006 even in a region where attraction by magnetic force is weak. Accordingly, the alignment error for the first getter 407 can be suppressed to fall within the allowable range. The first getter 407 can thus be satisfactorily produced on the wire 403.
In the above-described manner, it is possible to produce the first getter 407 using a substrate processing apparatus according to the present invention and produce an SED.

### (Second Embodiment)

FIG. 17A is a schematic view of the structure of an organic electroluminescence display which is one of image display apparatuses capable of being produced by applying a substrate processing apparatus according to the present invention.
Reference numeral 501 denotes a glass substrate; 502, an anode; 504, a hole-related layer; 505, a luminescent layer; 506, an electron transport layer; 507, an electron injection layer; and 508, a cathode. Note that the hole-related layer 504 includes a hole injection layer 504a and a hole transport layer 504b.
As for the operation, when a voltage is applied across the anode 502 and the cathode 508, a hole is injected into the hole injection layer 504a by the anode 502. On the other hand, an electron is injected into the electron injection layer 507 by the cathode 508. The injected hole and electron pass through the hole injection layer 504a and hole transport layer 504b and the electron injection layer 507 and electron transport layer 506, respectively, and reach the luminescent layer 505. The hole and electron having reached the luminescent layer 505 recombine with each other and emit light.
Appropriate selection of the material for the luminescent layer 505 makes it possible to emit red light, green light, and blue light that are light's three primary colors, thus resulting in implementation of a full-color image display apparatus.

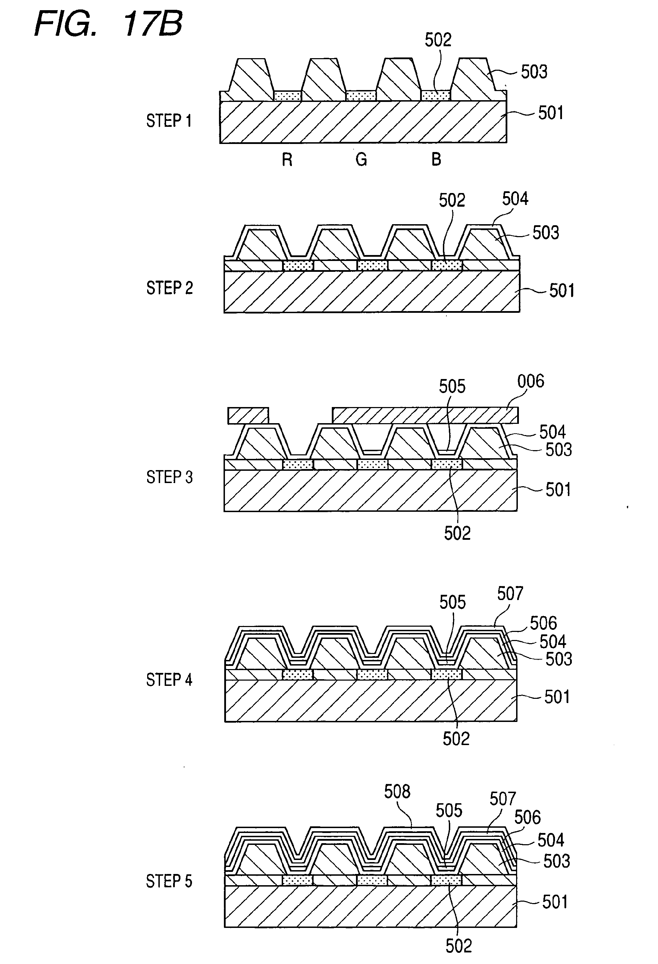

Production of the luminescent portion will be described with reference to FIG. 17B. Referring to FIG. 17B, one pixel composed of portions which emit light beams, respectively, of red R, green G, and blue B will be described. FIGS. 17B are views of steps showing a method for manufacturing a luminescent portion of an organic EL display using a substrate processing apparatus according to the present invention.

First, a Thin Film Transistor portion (hereinafter abbreviated as TFT) and a wiring portion are produced in a preceding step. After that, a conductive film with high reflectivity is formed on the substrate 501 such as a glass substrate which has undergone film formation processing for planarization. In step 1, the conductive film is patterned into a predetermined shape, thereby forming the anode electrode 502 on the substrate 501. In step 2, the element isolation film 503 made of a highly insulative material is formed to surround portions which emit light beams of red R, green G, and blue B on the anode electrode 502. With this operation, the adjacent portions R, G, and B which emit light are isolated from each other by the element isolation film 503.

In steps 3 and 4, the hole-related layer 504 (actually including the hole injection layer 504a and the hole transport layer 504b), the luminescent layer 505, the electron transport layer 506, and the electron injection layer 507 are sequentially produced on the anode electrode 502 by an evaporation method. In this embodiment, at least one layer of the hole injection layer 504a to the electron injection layer 507 can be produced by the above-described substrate processing apparatus according to the present invention. Each layer may be produced in the same manner as in the first embodiment.

In step 5, the cathode electrode 508 made of a transparent conductive film is stacked on the electron injection layer 507, thereby forming a luminescent portion of an organic EL display on the substrate 501. Finally, the luminescent portion on the substrate is coated with a sealing layer (not shown) made of a material with low moisture permeability.
When the luminescent layers 505 for R, G, and B are produced by the evaporation method, the glass substrate 501 is covered with a mask 006, as shown in step 3. It goes without saying that, at this time, the metal mask 006 and a magnet 007 sandwich the substrate 501 with the predetermined layers formed.

Step 3 shows production of the luminescent portion for red R. The luminescent portions for green G and blue B are thus covered with the mask in order to prevent a luminescent material for red R from entering the portions for green G and blue B. The mask is similarly used for the portions for green G and blue B as well. In the case of, e.g., a 5.2-inch (diagonal) 320 × 240 pixel full-color organic EL display, the pixel pitch is 0.33 mm (330 µm), and the sub-pixel pitch is 0.11 mm (110 µm). The pattern misalignment error allowable in this case is several microns or less. However, if the mask is floating, blurring occurs at an edge of a patterned region, and a pattern error cannot be brought within a required range.

The production of the hole transport layer 504b, the luminescent layer 505, the electron transport layer 506, and the electron injection layer 507 is performed in separate chambers in order to prevent each organic material from getting mixed in with another, and separate dedicated masks are used. A film formation process for each layer also requires high-accuracy alignment of the corresponding mask at the same position. Accordingly, high-accuracy and quick mask alignment is essential for increasing the productivity and yields of organic EL displays.
Demands for a display with a large display screen may increase further in the future. The need for high-accuracy and quick alignment of a large heavy mask is expected to grow increasingly at that time.

Therefore, a vacuum processing apparatus capable of quickly aligning a large mask with high accuracy, like one according to the present invention, is particularly suitable for manufacturing organic EL displays. Since use of a substrate processing apparatus according to the present invention allows suppression of the above-describe flotation of a mask, blurring at an edge of a patterned region can be suppressed, and a shift in formed pattern can be brought within an allowable range. More specifically, even if a border portion between S and N poles is present, since the adhesion between a substrate and a mask can be improved, effects of flotation of the mask can be reduced, and mask alignment accuracy can be improved.
As described above, it is possible to produce a luminescent portion using a substrate processing apparatus according to the present invention and produce an organic EL display.

## Claims

1. A substrate processing apparatus comprising:
a magnet which is arranged on a side opposite to a surface to be processed of a substrate at the time of processing the substrate and has a border portion between N and S poles; and
a magnetic mask which is arranged to face the surface to be processed of the substrate at the time of processing the substrate and has a patterned region and a frame region, the frame region having a thickness larger than a thickness of the patterned region, wherein
the frame region is made to face the border portion.

2. The substrate processing apparatus according to claim 1, wherein the magnetic mask is a metal mask.

3. The substrate processing apparatus according to claim 1, wherein the substrate processing apparatus is a film forming apparatus.

4. The substrate processing apparatus according to claim 1, wherein a thickness of the patterned region of the magnetic mask is 0.05 mm or less.

5. The substrate processing apparatus according to claim 1, wherein a thickness of the frame region of the magnetic mask is 0.1 mm or more.

6. The substrate processing apparatus according to claim 1, further comprising an electrostatic chuck for holding a surface opposite to the surface to be processed of the substrate, wherein
the magnet is placed on a side opposite to the substrate of the electrostatic chuck.

7. The substrate processing apparatus according to claim 6, wherein the electrostatic chuck has a trench for arranging the magnet in a surface where the magnet is to be placed.

8. A substrate processing method of arranging a magnetic mask which has a patterned region and a frame region, the frame region having a thickness larger than a thickness of the patterned region, on one surface of a substrate, arranging a magnet which has a border portion between N and S poles on a side opposite to the one surface to bring the magnetic mask into contact with the substrate by magnetic force of the magnet, and processing the surface of the substrate through the magnetic mask, comprising:
a step of arranging the magnet and the magnetic mask such that the frame region faces the border portion between N and S poles at the time of said contact.

9. The substrate processing method according to claim 8, wherein the magnetic mask is a metal mask.

10. The substrate processing method according to claim 8, wherein the substrate processing method is a film forming method.

11. The substrate processing method according to claim 8, wherein the thickness of the patterned region of the magnetic mask is 0.05 mm or less.

12. The substrate processing method according to claim 8, wherein the thickness of the frame region of the magnetic mask is 0.1 mm or more.

13. The substrate processing method according to claim 8, wherein a surface opposite to the one surface of the substrate is held by an electrostatic chuck, and the magnet is placed on a side opposite to the substrate of the electrostatic chuck.

14. The substrate processing method according to claim 13, wherein the electrostatic chuck has a trench for arranging the magnet on a surface where the magnet is to be placed.

15. An electron-emissive element display, wherein the electron-emissive element display is produced by the substrate processing apparatus according to claim 1.

16. An organic electroluminescence display, wherein the organic electroluminescence display is produced by the substrate processing apparatus according to claim 1.

17. An electron-emissive element display producing method comprising a step of forming a getter on a wire by the substrate processing method according to claim 8.

18. An organic electroluminescence display comprising a step of forming at least one layer of a hole injection layer, a hole transport layer, a luminescent layer, an electron transport layer, and an electron injection layer by the substrate processing method according to claim 8.
